# EUROPÄISCHE PATENTSCHRIFT

(11) **EP 1 830 194 B1**
(45) Veröffentlichungstag und Bekanntmachung des Hinweises auf die Patenterteilung: **26.11.2008**
(21) Anmeldenummer: 07003534.0
(22) Anmeldetag: 21.02.2007
(51) Int. Cl.: G01R 31/01, G01R 31/28

(54) **Prüfvorrichtung für Halbleiterbauelemente**
Testdevice for semiconductor components
Dispositif de test pour composants semiconducteurs

(30) Priorität: 01.03.2006 DE 102006009321
(43) Veröffentlichungstag der Anmeldung: 05.09.2007
(73) Patentinhaber: ATMEL Germany GmbH, 74072 Heilbronn (DE)
(72) Erfinder: Heinke, Matthias, 74081 Heilbronn (DE); Wieczorek, Heinrich, 74172 Obereisesheim (DE)
(74) Vertreter: Müller, Wolf-Christian

(56) Entgegenhaltungen:
- US-A- 5 065 089
- US-A1- 2001 030 551
- US-A1- 2004 222 809
- US-A1- 2005 062 463

## Beschreibung

Die vorliegende Erfindung betrifft eine Vorrichtung zum Prüfen von verschieden Halbeiterbauelementen einschließlich integrierter Halbleiterschaltkreise, so genannten ICs (integrated circuits), gemäß dem Oberbegriff des Patentanspruchs 1.

Nach der Vereinzelung von integrierten Halbleiterschaltkreisen werden diese in einem Testschritt einer Funktionskontrolle unterzogen. Dazu ICs innerhalb einer Testvorrichtung in Kontakt mit Testfassungen gebracht, um die Einzelbauteile auf ihre Funktionsfähigkeit zu prüfen. Diese Testvorrichtungen sind üblicherweise als "IC-Tester" oder "IC-Handler" bekannt.

Eine derartige Testvorrichtung ist beispielsweise aus der Druckschrift US 3408565 A bekannt. Weitere gattungsgemäße Testvorrichtungen sind in den Druckschriften US 5 065 089, US 2001 / 030551 A1, US 2004 / 222809 A1 und US 2005 / 062463 A1 offenbart.

Die Erfindung wird nachfolgend anhand von ICs als typischen Halbleiterbauelementen beschrieben, ohne jedoch auf diese beschränkt zu sein.
Die Bauelemente werden entweder lose, in Kunststoffröhren oder Metallmagazinen in den Ladebereich des Handlers eingefüllt und anschließend in Abhängigkeit von der Lademethode zum Testabschnitt des Handlers transportiert.
Der zur Handhabung der Bauelemente ausgelegte Handler enthält Transportvorrichtungen, die mittels pneumatischer, mechanischer oder manueller Steuerung für die dauernde Zufuhr und für die korrekte Ausrichtung der einzlenen ICs zu den Testfassungen sorgen. Die Testfassungen umfassen Kontakteinheiten mit je nach Anzahl der Kontakte des IC bis zu hundert Kontaktstiften so genannten POGOPins, die entsprechend der zu testenden Schaltung angeordnet sind. Die Testfassungen sind wiederum auf einem DUT-Board angeordnet, welches sich an der Außenseite des Handlers befindet und das über elektrische Kontakteinrichtungen zu einem programmgesteuerten Signalgenerator verfügt.

Die Kontaktierung findet innerhalb einer Kammer statt, in welcher die Halbleiterbauelemente auf die gewünschte Prüftemperatur erhitzt bzw. heruntergekühlt werden. Nach einer gewissen Haltezeit in der Kammer, die der Temperaturangleichung dient, werden die ICs einzeln von Haltevorrichtungen aufgenommen, die über Tragköpfe mit Vakuumpumpen verfügen und die die Bauelemente ansaugen. Mit Hilfe der Tragköpfe werden die ICs dann gegen die Kontaktstifte der Testfassungen gedrückt, um einen Kontakt zwischen den Anschlüssen des ICs und der Testfassung herzustellen. Nach Überprüfung der Funktion eines integrierten Halbleiterschaltkreises wird an den Tragköpfen die Vakuumpumpe kurzzeitig de- und mittels Druckluft ein Luftstoß aktiviert, damit sich der IC vom Tragkopf löst.

Während der Kontaktierung sendet der programmgesteuerte Signalgenerator Testsignale über die Testfassung auf dem DUT-Board an die elektronischen Schaltkreise auf dem IC aus und wertet die Antwortsignale, die von dem IC zurückkommen, aus. Weiterhin werden im Zuge der Funktionskontrolle Spannung und Stromfluss in den Halbleiterschaltkreisen geprüft.
Die Anforderungen an die Kontaktstifte sind hierbei sehr komplex. Kontaktstifte sind üblicherweise aus Stahl gefertigt und mit einem harten Material überzogen, das einen niedrigen elektrischen Widerstand und hohe Leitfähigkeit aufweist.
Zum einen hat sich in der Praxis gezeigt, dass sich an der äußeren Oberfläche der Kontaktstifte nach einigen Prüfvorgängen Oxide bilden, die den Übergangswiderstand erhöhen. Dadurch wird die Standzeit der Kontaktstifte bzw. der gesamten Testfassung erheblich verringert.

Zum anderen besteht die Problematik beim Testen von ICs darin, dass die Kontaktflächen oder Lötverbindungen eines elektronischen Bauelements typischerweise aus einem metallischem Material, wie beispielsweise Aluminium oder Lötzinn, welches an Luft eine Oxidschicht an seiner Oberfläche bildet, besteht. Dieses ist oftmals härter als das reine metallische Material. Beim Andrücken der Kontaktstifte an die Kontaktfläche muss diese Metalloxidschicht, die eine Dicke von mehreren µm aufweist, überwunden werden, Bekannte Kontaktstifte haben in ihrem Innern eine Feder, die es ermöglicht, während der Tests eine hohe Normalkraft mit der Spitze des Kontaktstifts auf den Kontaktpunkt des ICs auszuüben und dadurch die Metalloxidschicht zu durchdringen. Dabei werden die Kontaktstifte einerseits mechanisch beansprucht, andererseits lagen sich bei jedem Testvorgang geringe Mengen von Metalloxid an den Spitzen der Kontaktspitzen ab.
Gerade diese Ablagerungen des Metalloxids sind problematisch, da sie mit dem Metall der Kontaktstifte reagieren können, was jeweils von den vorhandenen Metallen, Temperaturen und Drücken abhängig ist. Weiterhin kann auch das Zinn der Lötverbindungen in die Kontaktspitzen diffundieren und dort metallisch Struktur verändernd wirken.

Je nachdem ob die ICs bei hohen, tiefen oder Raumtemperaturen zum Einsatz kommen wird die Temperatur in der Haltekammer entsprechend dem Prüfprogramm eingerichtet. Soll die Kammer gekühlt werden, kommt flüssiger Stickstoff zum Einsatz, der über gesonderte Leitungen in die Kammer gelangt. Die Erwärmung der Kammer erfolgt im Gegensatz dazu über Luft, die auch für die Druckluftversorgung der pneumatisch betriebenen Transporteinrichtungen verwendet wird. Während der Prüfung bei Raumtemperatur findet die Kontaktierung der ICs nicht im abgeschlossenen sondern offenen System statt. Dadurch wird den elektronischen Bauteilen gerade vor der Testphase bei Raumtemperatur oder bei hohen Temperaturen neuer Sauerstoff zugeführt, was eine Oxidbildung an der Oberfläche der Kontaktstifte bzw. an der Oberfläche der Kontaktflächen oder Lötverbindungen der ICs begünstigt.

Aufgrund dieser Gegebenheiten verschleißen die Kontaktstifte und somit die gesamten Testfassungen sehr schnell. Der Austausch der Kontaktstifte ist jedoch sehr teuer, da neben dem erforderlichen Material Ausfallzeiten in der Testphase entstehen, in welchen die gesamte Testvorrichtung bzw. der gesamte Handler stillsteht.

Daher sind aus der gegenwärtigen Praxis zur Erhöhung der Messsicherheit verschiedene Reinigungsmethoden für die Spitzen der Kontaktstifte, wie mechanisches oder chemisches Reinigen der der Kontaktstifte bekannt. Allerdings liegt der Nachteil dieser Verfahren darin, dass die Kontaktstifte beim Reinigen beschädigt werden können oder chemische Rückstände auf den Kontaktstiften verbleiben.

Aus diesem Grund wurde versucht, Kontaktstifte mit einer Oberfläche aus nicht oxidierendem oder nur minimal oxidierendem Metall herzustellen. Dazu werden Metalle wie Gold, Silber, Platin, Palladium, Iridium, Rhenium, Quecksilber und Osmium verwendet, die generell weniger reaktionsfreudig bezüglich Sauerstoff sind und vorteilhafte physikalische und elektrische Eigenschaften aufweisen. Außerdem wurden die Oberflächen der Kontaktstiftspitzen in der Form variiert, um eine möglichst geringe Oberfläche zu erzielen und somit den Kontaktbereich zwischen den Stiften und den ICs zu minimieren.

Weiterhin offenbart die WO 03027689 A1 einen Kontaktstift, dessen Oberfläche mit einer Palladium-Kobalt-Legierung überzogen ist, um die Haftung von Metalloxidablagerungen des Lötzinns an den Kontaktstiftspitzen zu verringern. Allerdings erhöht sich dadurch der elektrische Widerstand dieser Kontaktstifte gegenüber denjenigen, die eine Beschichtung mit Nickel oder Gold haben.

Nachteil der bisherigen Verfahren ist, dass diese jeweils zeitintensiv oder aufgrund der Verwendung teurer Materialien und Herstellungsverfahren sehr kostspielig sind.
Daher ist es Aufgabe der Erfindung, unter Vermeidung vorgenanter Nachteile die Standzeit der Kontaktstifte und die Messsicherheit der Testvorrichtung zu erhöhen.

Diese Aufgabe wird erfindungsgemäß durch eine Vorrichtung der eingangs genannten Art mit den Merkmalen des Patentanspruches 1 und ein Verfahren mit den Merkmalen des Anspruchs 8 gelöst. Günstige Ausgestaltungsformen sind Gegenstand von Unteransprüchen.

Demnach besteht das Wesen der Erfindung darin, dass bei einer Vorrichtung, mit der eine Vielzahl von vereinzelten Halbleiterbauelementen einer Funktionskontrolle unterzogen werden, als Medium für den Betrieb des pneumatischen Systems ein inertes Gas vorgesehen ist. Hierbei umfasst diese Vorrichtung in einer Testfassung integrierte Kontaktstifte, die einen mechanischen und elektrischen Kontakt zwischen der Testfassung und den integrierten Halbleiterschaltkreisen herstellen, ein mit der Testfassung verbundenes DUT-Board zur Übertragung elektrischer Signale von und an eine programmgesteuerte elektronische Schaltungsanlage, ein pneumatisches System mit Leitungs- und Steuerungseinrichtungen zum Betrieb wenigsten einer Transportvorrichtung und wenigstens einer Haltevorrichtung zur Aufnahme, Ausrichtung und Positionierung der vereinzelten Halbleiterbauelemente.

Untersuchungen der Anmelderin haben gezeigt, dass mit Hilfe der vorgenannten Vorrichtung vermieden wird, dass Luft bzw. Druckluft aus dem Transportsystem in den Bereich der Kontaktierung der ICs gelangt.
Durch die Verdrängung der Luft um den Kontaktierbereich der ICs, ergeben sich bei der Funktionskontrolle mehrere Vorteile gleichzeitig. Zum einen ist der Kontaktwiderstand an den Kontaktflächen der integrierten Halbleiterschaltkreise geringer, da die Oxidation der Kontaktflächen im Bereich der Kontaktierung wesentlich reduziert wird. Zum anderen kann sich auch an den Metalloberflächen der Kontaktstiftspitzen aufgrund der inerten Atmosphäre kein Oxid bilden.

In einer Weiterbildung der Erfindung ist zur Einleitung ein inertes Gas, vorzugsweise Stickstoff vorgesehen. Bei der Prüfung bei tiefen Temperaturen wird bereits flüssiger Stickstoff zur Abkühlung der ICs eingesetzt Durch die Verwendung von Stickstoff als Druckluft im pneumatischen System kann vermieden werden, dass auch geringe Mengen an Normalatmosphäre oder an reaktionsfreudigem Sauerstoff in die Vorrichtung gelangen.

Gemäß einer vorteilhaften Ausgestaltung der Vorrichtung sind die Leitungsund Steuerungseinrichtungen der pneumatischen Transport- und Haltevorrichtung zusätzlich als Spülvorrichtungen für die Testfassungen, die Kontaktstifte und Halbleiterbauelemente vorgesehen. Dies bedeutet, dass Düsen, die zum Transport der ICs innerhalb des Handlers dienen, gezielt angesteuert werden können, um eine inerte Atmosphäre in der Messkammer zu erzeugen bzw. um Partikel an Kontaktstiften etc. zu entfernen.

Eine Weiterbildung der Erfindung sieht vor, dass die Vorrichtung eine Temperaturregeleinrichtung enthält, die mehrere Kanäle und Düsen zur Steuerung der Temperatur in einer Haltekammer und im Kontaktierbereich der Prüfvorrichtung umfasst, wobei als Medium zur Erwärmung der Haltekammer und/oder des Kontaktierbereiches ein inertes Gas vorgesehen ist. Als vorteilhaft hat sich erwiesen, zur Versorgung der Temperaturregeleinrichtung und zum Temperieren der Halbleiterbauelemente das Gas aus den Leitungsund Steuerungseinrichtungen der pneumatischen Transport- und Haltevorrichtung vorzusehen.

Eine weitere Ausgestaltung der Erfindung sieht vor, dass zusätzliche Leitungs- und Steuerungseinrichtungen in der pneumatischen Transport- und Haltevorrichtung und /oder Temperaturregeleinrichtung vorgesehen sind, mittels derer Spülvorgänge mit inertem Gas unabhängig von programmierten Prüfvorgängen gesteuert werden. Dies bedeutet, dass auch bei der Prüfung der ICs bei Raumtemperatur oder hohen Temperaturen die Düsen der Prüfvorrichtung so steuerbar sind, dass je nach Bedarf und unabhängig von automatisch ablaufenden Prüfprogrammen durch manuelle Betätigung erwärmtes inertes Gas in den Kontaktierbereich geleitet werden kann.

Das Verfahren zum Prüfen einer Vielzahl von vereinzelten elektronischen Halbleiterbauelementen vorzugsweise Halbleiterschaltkreisen, wird dabei in den folgenden Schritten ausgeführt. Zunächst werden die einzelnen Bauelemente mittels eines Haltekopfes nach Verlassen der Klimakammer aufgenommen und anschließend relativ zu einer Testfassung mit Kontaktstiften positioniert. Dadurch dass der Transport der Bauelemente innerhalb der pneumatischen Halte- und Transportvorrichtung mittels eines inerten Gases erfolgt, werden die Bauelemente und die Testfassung beim Weitertransport der ICs durch die Düsen gleichzeitig gespült. Daraufhin werden die auf den Bauelementen angeordneten integrierten elektronischen Schaltkreise kontaktiert und eine elektrische Verbindung zwischen Bauelement und einer Testfassung hergestellt. Die Schritte "Aufnahme", "Positionieren", "Spülen" und "Kontaktieren" werden wiederholt bis die Prüfung an allen Bauelementen, die sich innerhalb der Vorrichtung befinden, abgeschlossen ist.

Eine Weiterbildung des Verfahrens sieht vor, dass die Bauelemente in einem Schritt vor dem Kontaktieren mittels flüssiger und/oder gasförmiger inerter Medien auf eine gezielte Prüftemperatur abgekühlt oder erwärmt werden.

Eine vorteilhafte Ausgestaltung des Verfahren sieht weiterhin vor, dass beim Prüfen bei hohen Temperaturen die Erwärmung der Bauelemente in einer dafür vorgesehenen Haltekammer mittels gasförmigen Stickstoffs, der den Leitungs- und Steuerungseinrichtungen der pneumatischen Halte- und Transportvorrichtung entnommen wird, erfolgt.

Anhand der Figuren soll die Erfindung näher beschrieben werden.
Fig. 1 zeigt schematisch einen Schnitt durch die Klimakammer und den Kontaktierbereich eines Handlers
Fig. 2 zeigt ein Detail aus dem Kontaktierbereich des Handlers

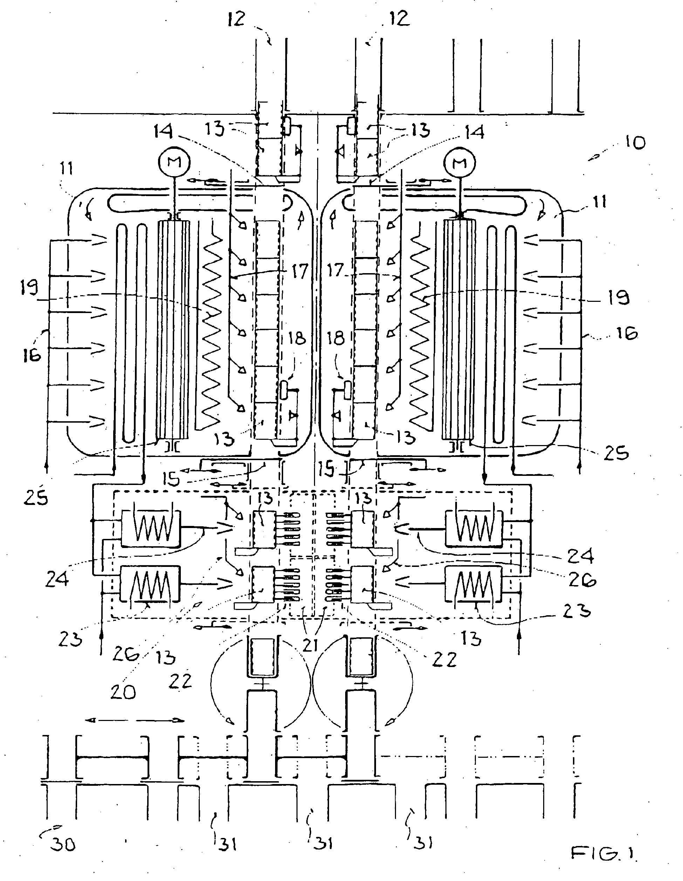

Fig. 1 zeigt eine Klimakammer 10 eines Handlers mit einer linken und einer rechten Haltekammer 11. Durch Ladeeinrichtungen 12 werden vereinzelte ICs 13 der Klimakammer 10 zugeführt. Die Haltekammern 11 sind jeweils durch einen Kammereingangsverschluss 14 und einen Kammerausgangsverschluss 15 gegenüber den offenen Bereichen des Handlers abgeschlossen, um die zu testenden ICs 13 auf eine gezielte Prüftemperatur aufzuheizen oder abzukühlen.
Es werden drei Temperaturbereiche unterschieden. Bei der Prüfung bei tiefen Temperaturen, die bei ca. -40 °C stattfindet, wird den Haltekammern 11 flüssiger Stickstoff durch gesonderte Leitungen und Düsen 16 zugeführt. Üblicherweise verläuft die Temperierung der ICs 13 programmgesteuert, so dass kein Einfluss auf die Atmosphäre innerhalb der Klimakammer 10 genommen werden kann. Der Transport der ICs 13 innerhalb der Klimakammer 10 erfolgt mittels einer pneumatisch gesteuerten Vorrichtung mit Leitungseinrichtungen und Düsen 17. Weiterhin sind Haltevorrichtungen 18 innerhalb der Ladeeinrichtungen 12 angeordnet, die für die Vereinzelung der ICs 13 zum Eintritt in einen Kontaktierbereich 20 sorgen.
Nach dem Verlassen der Haltekammer 11 werden die ICs 13 mittels weiterer Leitungs- und Steuereinrichtungen 26 der pneumatischen Transportvorrichtung an eine Messposition im Kontaktierbereich 20 transportiert. Dort werden die ICs 13 von einer Testfassung 21, die eine den Kontakten der ICs entsprechende Anzahl von Kontaktstiften 22 (Pogopins) enthält, kontaktiert und eine elektrische und mechanische Verbindung hergestellt. Die Testfassung 21 steht wiederum in Verbindung zu einem DUT-Board (nicht dargestellt), das sich an der Außenseite des Handlers befindet und das eine projektspezifische Messschaltungsanordnung umfasst und gleichzeitig zur Weiterleitung der Signale einen Signalgenerator und deren Auswertung dient.
Bei der Messung bei tiefen Temperaturen tritt oftmals zwischen IC 13 und der Außenseite des DUT-Boards ein Temperaturgefälle von 60°C auf, was zur Kondensation und zur Bildung von Feuchtigkeit im Kontaktierbereich 20 führen kann. Konstante Temperaturen und konstante Luftfeuchtigkeit sind jedoch für konstante Messqualität maßgebend. Aufgrund der Verwendung eines inerten Gases zur Kühlung der ICs 13 wird beim Austritt der ICs 13 aus der Haltekammer 11 oxidhaltiges Gas durch das inerte Gas aus dem Kontaktierbereich 20 verdrängt, so dass es nicht zu negativen Auswirkungen auf die Kontaktstifte 22 oder Kontaktstellen kann.

Anders verhält es sich üblicherweise bei Messungen bei Raumtemperatur, da hier kein Stickstoff zum Herunterkühlen eingesetzt werden muss. Gemäß der vorliegenden Erfindung werden daher die Leitungs- und Steuereinrichtungen 17, 26 der pneumatischen Transportvorrichtung verwendet, um im Kontaktierbereich 20 reaktionsfreudige Gase zu verdrängen. Dazu wird zum Betrieb der pneumatischen Transport- und Haltevorrichtung insgesamt Stickstoff eingesetzt, so dass die Leitungen und Düsen 17, 26 der pneumatischen Vorrichtungen beim Transport der ICs 13 Stickstoff in den Kontaktierbereich 20 einbringen. Weiterhin sind auch die Düsen 24, die sonst der Feinregulierung der Temperatur im Kontaktierbereich 20 dienen, mit zusätzlichen Ventilen und Steuereinrichtungen versehen, die auch unabhängig von vorprogrammierten Messabläufen betätigt werden können, so dass beispielsweise in regelmäßigen Abständen Stickstoff zugeführt werden kann.

Bei der Messung bei hohen Temperaturen bis zu 170° C werden die ICs 13 in der Haltekammer 11 mittels eines inerten Gases, das von einer Heizung 19 erhitzt und mittels eines Tangentiallüfters 27 in der Haltekammer 11 verteilt wird, auf die gewünschte Prüftemperatur gebracht. Bei der vorliegenden Erfindung wird hierbei das Gas aus der pneumatischen Transport- und Haltevorrichtung verwendet. Auch zur Feinregulierung der Temperatur, für die die Düsen 24 vorgesehen sind, wird das Gas aus der pneumatischen Transport- und Haltevorrichtung eingesetzt. Dieses wird bei Bedarf über weitere Heizwendeln 23 im Kontaktierbereich 20 erwärmt. Durch den Einsatz eines inerten Gases im gesamten Handler wird oxidhaltiges Gas aus den Klimakammern 10 und dem Kontaktierbereich 20 verdrängt, so dass sich weder an den Kontaktflächen der ICs 13 noch an den Kontaktstiften 22 Oxidablagerungen bilden, die die Messergebnisse verfälschen. Insgesamt wird die Standzeit der Testfassung dadurch wesentlich erhöht.

Nach Abschluss der Messung werden die ICs 13 an eine Sortiereinrichtung 30 weitertransportiert, wo fehlerhafte ICs von funktionsfähigen ICs separiert und in entsprechende Aufnahmeschächte 31 eingeführt werden.

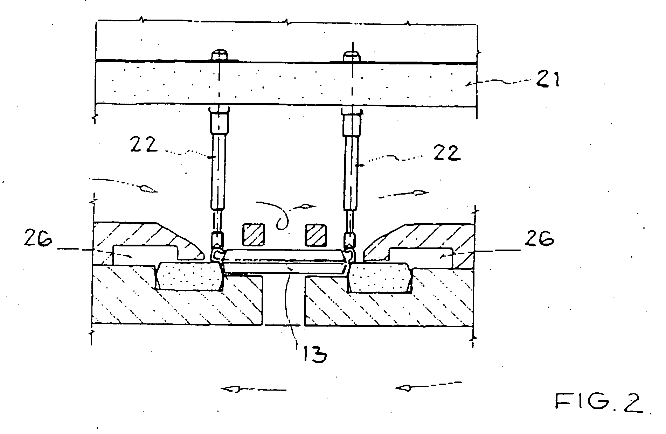

Fig. 2 zeigt im Detail zwei Kontaktstifte 22, deren Spitzen die Kontaktstellen eines ICs 13 berühren. Während der Kontaktierung sendet der programmgesteuerte Signalgenerator Testsignale über eine Testfassung 21 auf dem DUT-Board an die elektronischen Schaltkreise auf dem IC 13 aus und wertet die Antwortsignale, die von dem IC 13 zurückkommen, aus.
Je nach Ausführungsart des Handlers kann der Transport der ICs 13 über Gasströme, die über Leitungen und Transportdüsen 26 zugeführt werden, oder auch aufgrund der Gravitation oder über Pumpzylinder bewerkstelligt werden. Bei den beiden letztgenannten Varianten kann allerdings auch ein Gaseintrag erfolgen, der zur Beschleunigung der ICs oder zur Fehlerbeseitigung dient. In der Praxis hat sich gezeigt, dass durch den Eintrag von inertem Gas die Bildung von Oxiden an der äußeren Oberfläche der Kontaktstifte 22 verringert und die Standzeit der Kontaktstifte bzw. der gesamten Testfassung erheblich erhöht wurde.

### Bezugszeichenliste

- 10: Klimakammer
- 11: Haltekammer
- 12: Ladeeinrichtung
- 13: Halbleiterbauelement IC
- 14: Kammereingangsverschluss
- 15: Kammerausgangsverschluss
- 16: Klimagas-Düse
- 17: Leitungen und Transportdüsen
- 18: Haltevorrichtung
- 19: Heizung
- 20: Kontaktierbereich
- 21: Testfassung
- 22: Kontaktstift
- 23: Heizwendel
- 24: Klimagas-Düse
- 25: Tangentiallüfter
- 26: Leitungen und Transportdüsen
- 30: Sortierbereich
- 31: Aufnahmeschacht

## Patentansprüche

1. Prüfvorrichtung, mit der eine Vielzahl von vereinzelten Halbleiterbauelementen (13) einer Funktionskontrolle unterzogen wird, mit
• in einer Testfassung (21) integrierten Kontaktstiften (22), die einen mechanischen und elektrischen Kontakt zwischen der Testfassung (21) und den integrierten Halbleiterschaltkreisen (13) herstellen,
• einer mit der Testfassung (21) verbundene Aufnahmevorrichtung (DUT-Board) zur Übertragung elektrischer Signale von und an eine programmgesteuerte elektronische Schaltungsanlage,
• Leitungs- und Steuerungseinrichtungen (17, 26) zum Betrieb wenigstens einer pneumatischen Transport- und Haltevorrichtung zur Aufnahme, Ausrichtung und Positionierung der vereinzelten Halbleiterbauelemente (13),
**dadurch gekennzeichnet, dass**
• als Medium für den Betrieb der pneumatischen Vorrichtungen ein inertes Gas vorgesehen ist.

2. Vorrichtung gemäß Anspruch 1, **dadurch gekennzeichnet, dass** als Medium vorzugsweise Stickstoff vorgesehen ist.

3. Vorrichtung gemäß Anspruch 1 oder Anspruch 2, **dadurch gekennzeichnet, dass** die Leitungs- und Steuerungseinrichtungen (17, 26) der pneumatischen Transport- und Haltevorrichtung als Spülvorrichtungen für die Testfassungen (21), die Kontaktstifte (22) und Halbleiterbauelemente (13) vorgesehen sind.

4. Vorrichtung gemäß einem der vorhergehenden Ansprüche mit
einer Temperaturregeleinrichtung, die mehrere Kanäle und Düsen (16, 24) zur Steuerung der Temperatur in einer Haltekammer (11) und im Kontaktierbereich (20) der Prüfvorrichtung umfasst, wobei als Medium zur Erwärmung der Haltekammer (11) und/oder des Kontaktierbereiches (20) ein inertes Gas vorgesehen ist.

5. Vorrichtung gemäß Anspruch 4, **dadurch gekennzeichnet, dass** die Kanäle und Düsen (16, 24) der Temperaturregeleinrichtung als Spülvorrichtungen für die Testfassungen (21), die Kontaktstifte (22) und Halbleiterbauelemente (13) vorgesehen sind.

6. Vorrichtung gemäß Anspruch 4 oder 5, **dadurch gekennzeichnet, dass** zur Gasversorgung der Temperaturregeleinrichtung (16, 24) und zum Temperieren der Halbleiterbauelemente und zur Gasversorgung für die Leitungs- und Steuerungseinrichtungen (17, 26) der pneumatischen Transport- und Haltevorrichtung nur eine Gasquelle vorgesehen ist.

7. Vorrichtung gemäß einem der Ansprüche 4 bis 6, **dadurch gekennzeichnet, dass** zusätzliche Leitungs- und Steuerungseinrichtungen in der pneumatischen Transport- und Haltevorrichtung und /oder Temperaturregeleinrichtung vorgesehen sind, mittels derer Spülvorgänge mit inertem Gas unabhängig von programmierten Prüfvorgängen gesteuert werden.

8. Verfahren zum Prüfen einer Vielzahl von vereinzelten elektronischen Halbleiterbauelementen (13), mit einer Vorrichtung nach einem der Ansprüche 1 bis 6 **mit den Schritten:**
• Aufnahme eines einzelnen Halleiterbauelements (13) mittels eines Haltekopfes;
• Positionieren des Halbleiterbauelementes (13) relativ zu einer Testfassung (21) mit Kontaktstiften (22);
• Spülen der Halbleiterbauelemente (13) und der Testfassung (21) mit einem der den Leitungs- und Steuervorrichtungen der pneumatischen Halte- und Transportvorrichtung entnommenen inerten Gas.
• Kontaktieren der auf den Halbleiterbauelementen (13) angeordneten integrierten elektronischen Schaltkreise und Herstellung einer elektrischen Verbindung zwischen Halbleiterbauelement (13) und einer Testfassung (21);
• Wiederholung der Schritte "Aufnahme", "Positionieren", "Spülen" und "Kontaktieren".

9. Verfahren gemäß Anspruch 8, **dadurch gekennzeichnet, dass** die Halbleiterbauelemente in einem Schritt vor dem Kontaktieren mittels flüssiger und/oder gasförmiger inerter Medien auf eine gezielte Prüftemperatur abgekühlt oder erwärmt werden.

## Claims

1. Test device by which a plurality of discrete semiconductor elements (13) is subjected to a functional check, with
- contact pins (22), which are integrated in a test mount (21) and which produce a mechanical and electrical contact between the test mount (21) and the integrated semiconductor circuits (13),
- a mounting device (DUT board), which is connected with the test mount (21), for transmission of electrical signals from and to a program-controlled electronic circuit installation,
- conducting and control devices (17, 26) for operation of at least one pneumatic transporting and holding device for mounting, aligning and positioning the discrete semiconductor elements (13),
**characterised in that**
an inert gas is provided as medium for operation of the pneumatic devices.

2. Device according to claim 1, **characterised in that** preferably nitrogen is provided as medium.

3. Device according to claim 1 or 2, **characterised in that** the conducting and control devices (17, 26) of the pneumatic transporting and holding device are provided as washing devices for the test mounts (21), the contact pins (22) and semiconductor elements (13).

4. Device according to any one of the preceding claims with a temperature regulating device, which comprises several channels and nozzles (16, 24), for control of the temperature in a holding chamber (11) and in the contact region (20) of the test device, wherein an inert gas is provided as medium for heating the holding chamber (11) and/or the contact-making region (20).

5. Device according to claim 4, **characterised in that** the channels and nozzles (16, 24) of the temperature regulating device are provided as washing devices for the test mounts (21), the contact pins (22) and semiconductor element (13).

6. Device according to claim 4 or 5, **characterised in that** only one gas source is provided for the gas supply of the temperature regulating device (16, 24) and for temperature control of the semiconductor elements and for gas supply of the conducting and control devices (17, 26) of the pneumatic transporting and holding device.

7. Device according to any one of claims 4 to 6, **characterised in that** additional conducting and control devices are provided in the pneumatic transporting and holding device and/or temperature regulating device, by means of which washing processes with inert gas are controlled independently of programmed test procedures.

8. Method of testing a plurality of discrete electronic semiconductor elements (13), with a device according to any one of claims 1 to 6, comprising the steps:
- mounting an individual semiconductor component (13) by means of a retaining head;
- positioning the semiconductor element (13) relative to a test mount (21) with contact pins (22);
- washing the semiconductor elements (13) and the test mount (21) with an inert gas removed from the conducting and control devices of the pneumatic holding and transporting device;
- making contact with the integrated electronic circuits arranged on the semiconductor components (13) and producing an electrical connection between semiconductor element (13) and a test mount (21); and
- repeating the steps of "mounting", "positioning", "washing" and "contact-making".

9. Method according to claim 8, **characterised in that** the semiconductor elements are cooled or heated by means of liquid and/or gaseous inert media to a selected test temperature prior to the contact-making.

## Revendications

1. Dispositif de test permettant de soumettre une pluralité de composants semi-conducteurs (13) à une fonction de contrôle, comprenant
. des fiches de contact (22) intégrées dans une douille de test (21) établissant un contact mécanique et électrique entre la douille de test (21) et les circuits intégrés semi-conducteurs (13),
. un dispositif de réception (DUT-Board) relié à la douille de test (21) pour la transmission de signaux électriques en provenance de et en direction d'une installation de circuit électronique à cycles automatiques,
. des installations de liaison et de commande (17,26) pour le fonctionnement d'au moins un dispositif pneumatique de transport et de soutien pour la réception, l'orientation et le positionnement de chacun des composants semi-conducteurs (13),
**caractérisé en ce que**
. l'on utilise un gaz inerte comme fluide pour le fonctionnement des dispositifs pneumatiques.

2. Dispositif selon la revendication 1, **caractérisé en ce que** l'on utilise comme fluide de préférence de l'azote.

3. Dispositif selon la revendication 1 ou 2, **caractérisé en ce que** les installations de liaison et de commande (17, 26) du dispositif pneumatique de transport et de soutien sont prévus en tant que dispositifs de nettoyage pour les douilles de test (21), les fiches de contact (22) et les composants semi-conducteurs (13).

4. Dispositif selon l'une quelconque des revendications précédentes comprenant un dispositif de réglage de la température qui comporte plusieurs canaux et buses (16, 24) pour le contrôle de la température dans une chambre de retenue (11) et dans la zone de connexion (20) du dispositif de test, un gaz inerte étant prévu comme fluide pour chauffer la chambre de retenue (11) et/ou la zone de connexion (20).

5. Dispositif selon la revendication 4, **caractérisé en ce que** les canaux et les buses (16, 24) du dispositif de réglage de la température sont prévus comme dispositifs de nettoyage pour les douilles de test (21), les fiches de contact (22) et les composants semi-conducteurs (13).

6. Dispositif selon la revendication 4 ou 5, **caractérisé en ce que** l'on prévoit une source unique de gaz pour l'alimentation en gaz du dispositif de réglage de la température (16, 24), pour équilibrer la température des composants semi-conducteurs et pour l'alimentation en gaz des dispositifs de transmission et de commande (17, 26) du dispositif pneumatique de transport et de soutien.

7. Dispositif selon l'une quelconque des revendications 4 à 6, **caractérisé en ce que** l'on prévoit des installations supplémentaires de liaison et de commande dans le dispositif pneumatique de transport et de soutien et/ou dans le dispositif de réglage de la température, au moyen desquels on commande des opérations de nettoyage avec du gaz inerte indépendamment d'opérations de test programmées.

8. Procédé pour tester une pluralité de composants électroniques semi-conducteurs individuels (13) au moyen d'un dispositif selon l'une quelconque des revendications 1 à 6 comprenant les étapes suivantes :
. réception d'un composant semi-conducteur individuel (13) au moyen d'une tête de soutien ;
. positionnement du composant semi-conducteur (13) par rapport à une douille de test (21) comprenant des fiches de contact (22) ;
. nettoyage des éléments semi-conducteurs (13) et de la douille de test (21) au moyen d'un gaz inerte provenant d'installations de liaison et de commande du dispositif pneumatique de soutien et de transport ;
. connexion des circuits électroniques intégrés disposés sur les composants semi-conducteurs (13) et établissement d'une liaison électrique entre composant semi-conducteur (13) et une douille de test (21) ;
. répétition des étapes de "réception", de "positionnement", de "nettoyage" et de "connexion".

9. Procédé selon la revendication 8, **caractérisé en ce que** les composants semi-conducteurs sont refroidis ou chauffés pour atteindre une température de test adéquate lors d'une étape précédant la connexion au moyen de fluides inertes liquides et/ou gazeux.
